# EUROPEAN PATENT SPECIFICATION

(11) **EP 2 104 998 B1**
(45) Date of publication and mention of the grant of the patent: **03.04.2013**
(21) Application number: 07863798.0
(22) Date of filing: 01.11.2007
(51) Int. Cl.: H04L 27/36

(54) **WIRELESS COMMUNICATION UNIT, LINEARISED TRANSMITTER CIRCUIT AND METHOD OF LINEARISING THEREIN**
DRAHTLOSE KOMMUNIKATIONSEINHEIT, LINEARISIERTE SENDERSCHALTUNG UND VERFAHREN ZUR LINEARISIERUNG DARIN
UNITÉ DE COMMUNICATION SANS FIL, CIRCUIT D'ÉMETTEUR LINÉARISÉ ET PROCÉDÉ DE LINÉARISATION DE CELUI-CI

(30) Priority: 17.01.2007 GB 0700866
(43) Date of publication of application: 30.09.2009
(73) Proprietor: Motorola Solutions, Inc., Schaumburg IL 60196 (US)
(72) Inventor: BEN-AYUN, Moshe, 67899 Tel Aviv (IL); GROSSMAN, Ovadia, 67899 Tel Aviv (IL); ROZENTAL, Mark, 67899 Tel Aviv (IL)
(74) Representative: Treleven, Colin
(86) International application number: PCT/US2007/083392
(87) International publication number: WO 2008/088604

(56) References cited:
- GB-A- 2 323 987
- US-A- 5 066 923
- US-A- 5 959 499
- US-A1- 2005 123 064
- US-A1- 2006 050 810
- US-A1- 2006 234 654

## Description

### TECHNICAL FIELD

This invention relates generally to a radio transmitter in a wireless communication unit. The invention is applicable to, but not limited to, a training mechanism to configure a radio transmitter that employs a linearisation technique in order to provide a stable, linear output.

### BACKGROUND

Wireless communication systems, for example cellular telephony or private mobile radio (PMR) communication systems, typically provide for radio telecommunication links to be arranged between a plurality of base transceiver stations (BTSs) and a plurality of subscriber units, often termed mobile stations (MSs). The term mobile station generally includes both hand-portable and vehicular mounted radio units. Radio frequency (RF) transmitters are located in both BTSs and MSs in order to facilitate wireless communication between the communication units.

In the field of this invention, it is known that there is continuing pressure to better utilise a limited radio spectrum available for radio communication systems, which is focusing attention on a development of spectrally efficient linear modulation schemes. By using spectrally efficient linear modulation schemes, more communication units are able to share allocated spectrum within a defined geographical coverage area (communication cell). An example of a digital mobile radio system that uses a linear modulation method, such as π/4 digital quaternary phase shift keying (DQPSK), is a TErrestrial Trunked RAdio (TETRA) system, developed by the European Telecommunications Standards Institute (ETSI).

Since envelopes of these linear modulation schemes fluctuate, intermodulation products can be generated in non-linear RF power amplifier(s) (PAs). Specifically in a digital PMR market, restrictions on out-of-band (interfering) emissions are severe (to an order of -60dBc to -70dBc relative to a power in a transmitted frequency channel). Hence, linear modulation schemes used in this scenario require highly linear transmitters.

An actual level of linearity needed to meet particular out-of-band emission limits, is a function of many parameters, of which the most critical parameters are modulation type and bit rate. Quantum processes within a typical RF PA device are non-linear by nature. A straight line may only approximate a transfer function of the power amplifier when a small portion of consumed direct current (DC) power is transformed into RF power, as in an ideal linear amplifier case. This mode of operation provides a low efficiency of DC to RF power conversion, which is unacceptable for portable units.

One emphasis in portable PMR equipment is to increase battery life. Hence, it is useful to maximise operating efficiencies of the amplifiers used. To achieve both linearity and efficiency, so called linearisation techniques are used to improve a linearity performance of the more efficient classes of amplifier, for example class AB, B or C amplifiers. One such linearisation technique, often used in designing linear transmitters, is Cartesian Feedback. This is a 'closed loop' negative feedback technique, which sums a baseband feedback signal in its digital 'I' and 'Q' formats with a corresponding generated 'I' and 'Q' input signals in a forward path. Linearising of the PA output requires accurate setting and on-going control of a phase and amplitude of a feedback signal.

Details of an operation of such a linearisation technique are described in the paper "Transmitter Linearisation using Cartesian Feedback for Linear (time division multiple access) TDMA Modulation" by M. Johansson and T. Mattsson 1991 IEEE.

A lineariser circuit optimises a performance of a transmitter, for example to comply with linearity or output power specifications of a communication system, or to optimise an operating efficiency of the transmitter power amplifier. Operational parameters of the transmitter are adjusted to optimise the transmitter performance and include, as an example, one or more of the following: amplifier bias voltage level, input power level, phase shift of a signal around a feedback path. Such adjustments are performed by say, a microprocessor. Due to a sensitivity performance of such transmitter circuits, a range of control and adjustment circuits and/or components are needed so that a linear and stable output signal can be achieved under all operating circumstances.

All linearisation techniques require a finite amount of time in which to linearise the performance of a given amplifying device. The 'linearisation' of the amplifying device is often achieved by initially applying a training sequence to a lineariser circuit and the amplifying device in order to determine levels of phase and gain distortion introduced by the linearisation loop and the amplifying device. Once phase and gain distortion levels have been determined, they can be compensated for, generally by adjusting feedback components/parameters.

To accommodate for such linearisation requirements, communication systems typically allocate specific training periods for individual users to train their transmitters. The TErrestrial Trunked RAdio (TETRA) standard includes a time frame, termed a Common Linearisation Channel (CLCH) as is described in the UK Patent Application with publication number GB2272133, to provide a full-training period approximately once every second. The CLCH frame allows a radio to 'train' prior to gaining access to the TETRA communication system. However, a radio having to wait up to one second before training and then accessing the system is undesirable. To minimise the effect of this significant delay in call set-up times, and also provide an additional period for fine tuning a radio's output characteristics, due to changes in temperature, supply voltage or frequency of operation, a reduced training sequence has been inserted at the beginning of each TETRA traffic time slot for a radio allocated that slot to perform a minimal amount of training or fine tuning. This period may be used for phase training.

An example of such a training sequence is described in US Patent No. 5,066,923 of Motorola Inc., which describes a training scheme where a phase of a transmitter amplifier is adjusted in an 'open-loop' mode and a gain of a transmitter amplifier is adjusted when a feedback loop is closed.

US5959499 provides a linearization system for generating a predistorted drive signal for a nonlinear transmission path. An analogue feedback system is coupled to a computation unit, during a training mode. The computation unit receives a complex input signal and a complex error signal. The computation unit determines complex predistortion gain coefficients during the training mode, and generates the predistorted drive signal during the operation mode.

During phase training, a Cartesian feedback loop may be configured to be 'open loop', for example, a switch may be used to prevent the fed-back signal from being combined with a signal routed through the transmitter.

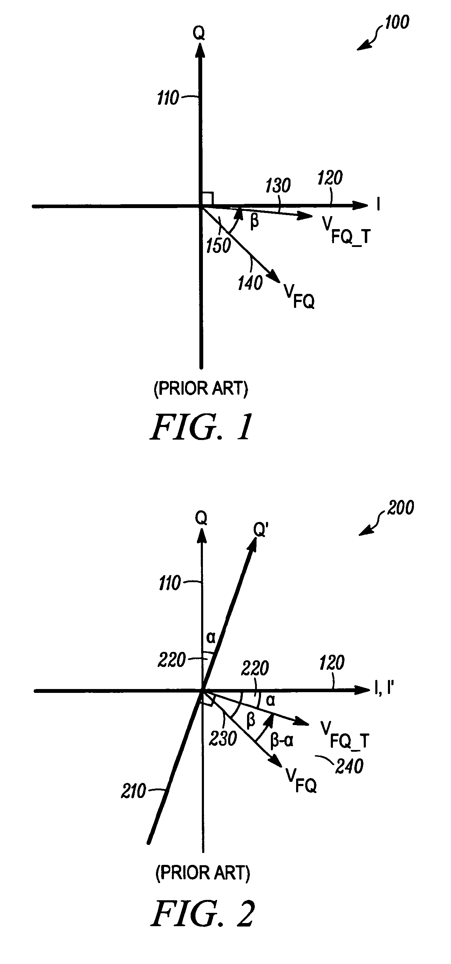

FIG. 1 illustrates a phase diagram 100 with a perfect I/Q quadrature balance, namely a 90-degree phase difference between the 'I'-channel 120 and the 'Q'-channel 110. One known method for controlling/setting phase and amplitude levels around a feedback loop is described here. The Cartesian loop may be opened and a positive baseband signal applied to an input of the 'I'-channel. Phase training control circuitry monitors a signal before switching on a 'Q'-channel - indicated as Vfq 140. A successive approximation register (SAR) phase training algorithm controls a phase shifter and is arranged to minimise the Vfq voltage. Once the SAR algorithm has completed, a phase correction signal corrects a loop phase from Vfq 140 to Vfq_t 130 by an angle β 150. A voltage value measured on the 'Q'-channel prior to the switch may then be reduced to a level close to zero. In one embodiment of the invention, the phase training and adjustment process is repeated for a negative baseband signal input to the 'I'-channel. Calculated results from both positive and negative training applied to the `I'-channel are averaged and used to adjust a phase shift around both the 'I'-channel loop and the `Q'-channel loop.

In practice, a perfect I-Q 90-degree relationship is rarely achieved. This imbalance results from various component tolerances within the respective `I' and 'Q' loops. An unbalanced phase relationship 200 is illustrated in FIG. 2. Here, Q' is the actual loop's quadrature axis 210. The Q' axis 210 deviates from an ideal Q axis 110 by α degrees 220. Again, Vfq is minimized using Q' axis 210 as quadrature. In a similar manner, a gain applied to, and/or provided by, the various components in the linearization loop can cause a quadrature amplitude imbalance between the `I'-channel and the 'Q'-channel.

From FIG. 2, it can be seen that instead of correcting a loop phase shift by β degrees 230, a phase training process may correct a loop phase by β - α degrees 240. This means that phase training provides a result that is inaccurate by α degrees 220.

Accurate phase training is a critical stage in linearisation of such transmitter circuits, as phase accuracy has a substantial effect on loop stability and wideband noise.

The inventors of the invention have identified that interfering transmissions from nearby transmitters may be leaked into a wireless communication unit's feedback path via its antenna, and may therefore affect an integrity and accuracy of phase shift calculations. In this scenario a phase training algorithm performed by a transmitter, which is a victim to such interfering transmissions from nearby transmitters, provides an incorrect result. This may lead to a Cartesian loop becoming unstable. One reason for an incorrect phase shift calculation emanates from the interfering transmitter signal adding noise to a phase training signal in a feedback path of the Cartesian loop.

Recently, transmitters employing Cartesian feedback loops have been able to use algorithms to better process and remove interfering signals, thereby avoid using expensive and large isolators. It has been identified that the aforementioned problem applies particularly to transmitters employing Cartesian feedback loops without isolators.

Thus, there exists a need to provide an improved wireless communication unit, a transmitter linearisation integrated circuit, and in particular a method for improving amplitude and phase training accuracy, wherein the abovementioned disadvantages may be alleviated.

### SUMMARY OF THE INVENTION

According to a first aspect of the present invention there is provided a wireless communication unit, as defined in claim 1 of the accompanying claims.

According to a second aspect of the present invention there is provided a method of linearising a transmitter, as defined in claim 7 of the accompanying claims.

Further features of the invention are as defined in the accompanying dependent claims and are disclosed in the embodiments of the invention to be described.

### BRIEF DESCRIPTION OF THE DRAWINGS

The accompanying figures, where like reference numerals refer to identical or functionally similar elements throughout the separate views and which together with the detailed description below are incorporated in and form part of the specification, serve to further illustrate various embodiments and to explain various principles and advantages all in accordance with the present invention.
FIG. 1 shows a known phase diagram of an ideal I-Q relationship in a feedback loop of a linear transmitter arrangement.
FIG. 2 shows a known phase diagram of an unbalanced I-Q relationship in a feedback loop of a linear transmitter arrangement.
FIG. 3 illustrates a block diagram of a wireless communication unit adapted to support embodiments of the invention.
FIG. 4 illustrates a block diagram of a linearised phase transmitter topology adapted in accordance with embodiments of the invention.
FIG. 5 illustrates a flowchart of a linearisation training process in accordance with embodiments of the invention.

### DESCRIPTION OF EMBODIMENTS OF THE INVENTION

Before describing in detail embodiments that are in accordance with the present invention, it should be observed that the embodiments reside primarily in combinations of method steps and apparatus components related to a method and apparatus for detecting a synchronisation signal. Accordingly, the apparatus components and method steps have been represented where appropriate by conventional symbols in the drawings, showing only those specific details that are pertinent to understanding the embodiments of the present invention so as not to obscure the disclosure with details that will be readily apparent to those of ordinary skill in the art having the benefit of the description herein. Thus, it will be appreciated that for simplicity and clarity of illustration, common and well-understood elements that are useful or necessary in a commercially feasible embodiment may not be depicted in order to facilitate a less obstructed view of these various embodiments.

It will be appreciated that embodiments of the invention described herein may be comprised of one or more generic or specialized processors (or "signal processors") such as microprocessors, digital signal processors, customized processors and field programmable gate arrays (FPGAs) and unique stored program instructions (including both software and firmware) that control the one or more processors to implement, in conjunction with certain non-processor circuits, some, most, or all of the functions of the method and apparatus for detecting a synchronisation signal described herein. The non-processor circuits may include, but are not limited to, a radio receiver, a radio transmitter and user input devices. As such, these functions may be interpreted as steps of a method to perform the detecting of a synchronisation signal described herein. Alternatively, some or all functions could be implemented by a state machine that has no stored program instructions, or in one or more application specific integrated circuits (ASICs), in which each function or some combinations of certain of the functions are implemented as custom logic. Of course, a combination of the two approaches could be used. Both the state machine and ASIC are considered herein as a "signal processor" for purposes of the foregoing discussion and claim language.

Moreover, an embodiment of the present invention can be implemented as a computer-readable storage element or medium having computer readable code (e.g., processor-implementable instructions) stored thereon for programming a computer (e.g., comprising a signal processor) to perform a method as described and claimed herein. Examples of such computer-readable storage elements include, but are not limited to, a hard disk, a CD-ROM, an optical storage device and a magnetic storage device. Further, it is expected that one of ordinary skill, notwithstanding possibly significant effort and many design choices motivated by, for example, available time, current technology, and economic considerations, when guided by the concepts and principles disclosed herein will be readily capable of generating such software instructions and programs and ICs with minimal experimentation.

Generally speaking, the various embodiments provide a wireless communication unit, a linearised transmitter integrated circuit and improved method of linearising a transmitter for improving amplitude and phase training accuracy

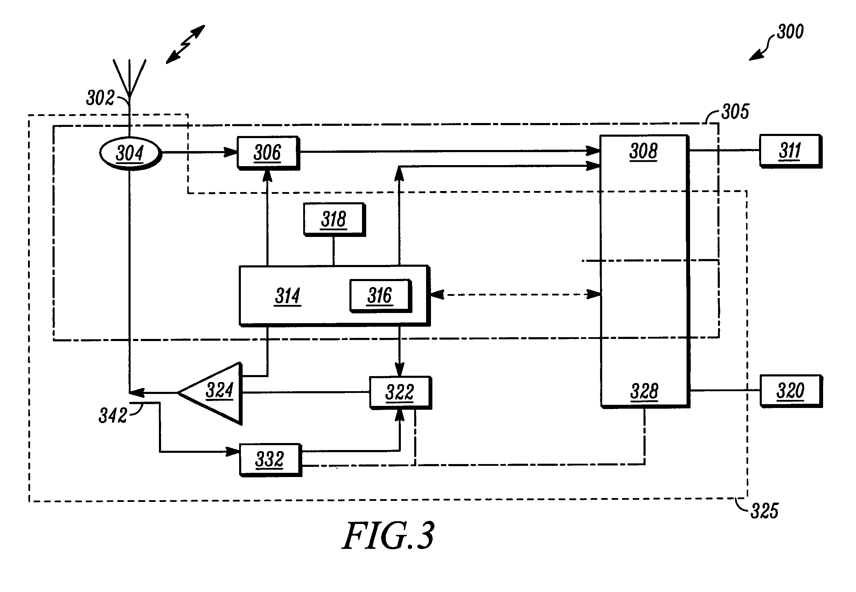

Referring now to FIG. 3, there is shown a block diagram of a wireless TETRA subscriber communication unit 300 adapted to support embodiments of the invention. For the sake of clarity, the wireless TETRA subscriber communication unit 300 is shown as divided into two distinct portions - a receiver chain 305 and a transmitter chain 325.

The wireless TETRA subscriber communication unit 300 contains an antenna 302. The antenna 302 is coupled to an antenna switch 304 that provides signal control of RF signals in the wireless TETRA subscriber communication unit 300, as well as isolation between the receiver chain 305 and transmitter chain 325. Clearly, the antenna switch 304 may be replaced with a duplex filter, for frequency duplex communication units, as is known to those skilled in the art.

For completeness, the receiver chain 305 of the wireless TETRA subscriber communication unit 300 will be briefly described. The receiver chain 305 includes receiver front-end circuit 306 (effectively providing reception, filtering and intermediate or base-band frequency conversion). The receiver front-end circuit 306 is serially coupled to signal processing logic (generally realised by at least one digital signal processor (DSP)) 308. A controller 314 is operably coupled to the receiver front-end circuit 306. The controller 314 is arranged to perform overall functional control of the wireless TETRA subscriber communication unit 300. A memory device 316 stores a wide array of data, such as decoding/encoding functions and the like, as well as amplitude and phase settings for the linearised transmitter to ensure a linear and stable output. A timer 318 is operably coupled to the controller 314 to control the timing of operations, namely the transmission or reception of time-dependent signals.

As regards the transmit chain 325, this essentially includes signal processing logic 328, lineariser circuitry (including transmitter/ modulation circuitry) 322 and an up-converter/power amplifier 324. The signal processing logic 328, lineariser circuitry 322 and the up-converter/power amplifier 324 are operationally responsive to the controller 314, with an output from the power amplifier 324 coupled to the antenna switch 304. A feedback circuit includes a down-converter 332, which forms together with the lineariser circuitry 322 power amplifier 324 and directional coupler 342 a real-time Cartesian feedback loop to ensure a linear, stable transmitter output.

Prior to transmitting real data, the linearised transmitter of embodiments of the invention employs a training algorithm to determine appropriate gain and phase adjustment parameters to apply to components within the loop to ensure a stable, linear output. Notably, embodiments of the invention propose a mechanism that improves an accuracy of the phase training, for example utilising the training algorithm described in US Patent No. 5,066,923 of Motorola Inc. In particular, embodiments of the invention propose a mechanism to introduce one or more loop filters to one or more feedback paths, solely during a phase training operation, in order to remove or negate potentially damaging effects of a nearby transmitter.

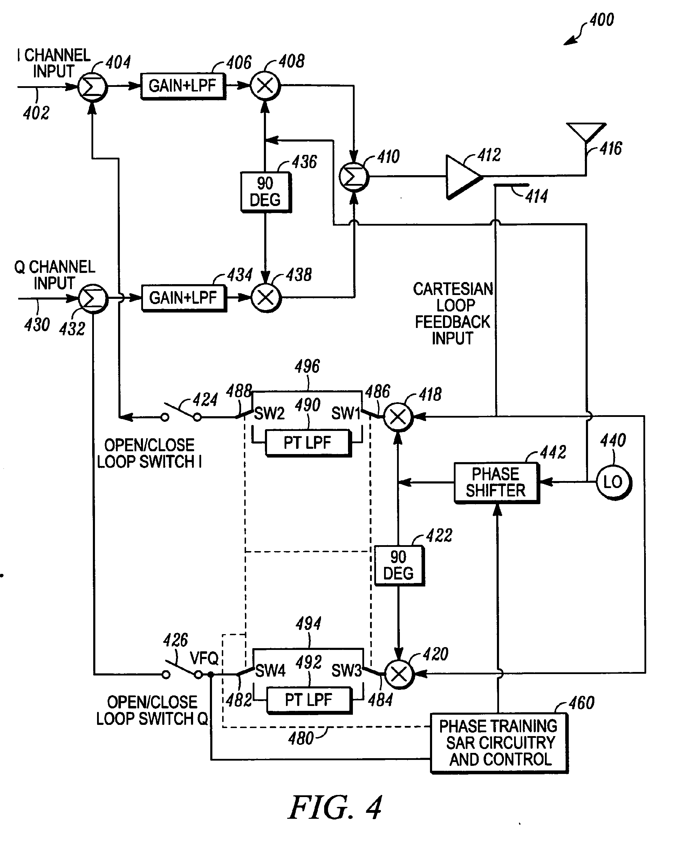

FIG. 4 shows a more detailed Cartesian loop configuration 400, adapted to support embodiments of the invention. A phase training signal, for example a sine wave, is input to an 'I'-channel 402. The phase training signal is not combined with any other signal in summing junction 404, as the circuit has been arranged for open-loop operation by controlling switch 424 (with a similar control for `Q'-channel with switch 426). The input phase training signal is then input to a gain and low-pass filter block 406 where it is amplified and filtered. The amplified input signal is then up-converted by mixing it with a signal from local oscillator 440 in mixer 408. The up-converted signal is then routed to RF amplifier chain 412, where a portion of an amplified RF signal is fed back via directional coupler 414.

The portion of amplified RF signal is routed to down-conversion mixer 418, where it is mixed with a phase-shifted 442 version of a signal from local oscillator 440. An amount of phase shift to be introduced to one or more components within the feedback loop is controlled by a phase calculation and adjustment function 460.

In accordance with embodiments of the invention, a second phase training sequence is now applied to `Q'-channel input 430. A phase training signal input to the `Q'-channel in this embodiment may be substantially the same sine wave that was previously input to the 'I'-chancel. The phase training signal is not combined with any other signal in summing junction 432, as the circuit has been arranged for open-loop operation by controlling switch 426. The `Q'-channel input signal is then input to a gain and low-pass filter block 434 where it is amplified and filtered. The amplified filtered, input phase training signal is then up-converted by mixing it with a '90' degree (436) phase-shifted representation of a signal from the local oscillator 440 in mixer 438. The up-converted signal is then routed to the RF amplifier chain 412, where a portion of the amplified RF signal is fed back via directional coupler 414.

The portion of the amplified RF signal is routed to down-conversion mixer 420, where it is mixed with a phase-shifted 442 version of the local oscillator signal. The phase-shifted version of the local oscillator signal has been further phase shifted by ninety-degrees 422 to account for an ideal I-Q quadrature nature of the lineariser circuit. The amount of phase shift to be introduced into one or more component(s) in the feedback loop is again controlled by the phase calculation and loop adjustment function 460.

In this manner, the phase shift of both the 'I'-channel loop and the `Q'-channel loop, through all of the components up to the switch point, is measured. Once the respective phase-shifts have been calculated, they are compensated for by appropriate adjustment of the phase-shifter, under control of the phase calculation and loop adjustment function 460.

Notably, in accordance with embodiments of the invention, the lineariser circuit incorporates phase adjustment circuitry and control logic 460 that has been adapted to apply a switch control signal 480 to a series of switches 482, 484, 486 and 488 introduced into the feedback paths. By appropriate opening and closing of the switches 482, 484, 486 and 488, during a phase training routine, the phase adjustment circuitry and control logic 460 is able to route respective `I' and 'Q' feedback paths through either low pass filters (LPFs) 490, 492 or bypass paths 496, 494.

Thus, in accordance with embodiments of the invention, switchable in/out low pass filters (PT LPF) are added to `I' and `Q' channels of a feedback path of Cartesian loop transmitter. The LPFs are switched into the feedback path only during a phase training period, for example when the loop is 'open'. In this manner, any interfering signal from a nearby transmitter that adds noise to a phase training signal is filtered, thereby removing any wideband noise and providing a correct phase training result. Subsequently, during closed-loop operation (for example after phase training), the low pass filters are bypassed, using switches sw1 486, sw2 488, sw3 484 and sw4 482. Thus, following phase training, a phase adjustment is calculated and used to set a correct phase value for closed-loop operation.

For example, in one embodiment of the invention it is envisaged that one or more filters may be switched into the feedback path during a phase training process in response to identifying a nearby interfering transmission.

It is envisaged that a typical example of filter characteristics could be: a Butterworth 3-pole filter with a 3-dB bandwidth of 20 kHz, where noise to be removed is an on-channel signal from interfering transmitters. In one embodiment of the invention, a cut-off frequency of a filter and/or a phase training squiggle frequency may be programmable into a Cartesian loop linearization IC, say via a serial-paralled interface.

Once a phase training process has been performed, resulting in a quadrature balance in phase between 'I'-chancel and `Q'-channel, a mechanism to compensate for quadrature amplitude imbalance between the 'I'-channel and the `Q'-channel within the loop may be performed, using one of the aforementioned referenced documents.

It is envisaged that the aforementioned training mechanism may be implemented using a signal processor function. More generally, embodiments of the invention may be implemented in a wireless communication unit in any suitable manner for example by re-programming or adapting a signal processor in the wireless communication unit. For example, a new processor may be added to a conventional wireless communication unit, or alternatively existing parts of a conventional wireless communication unit may be adapted, for example by re-programming one or more processors therein. As such the adaptation may be implemented in the form of processor-implementable instructions stored on a storage medium, such as a floppy disk, hard disk, programmable read-only memory (PROM), random access memory (RAM) or any combination of these or other storage media.

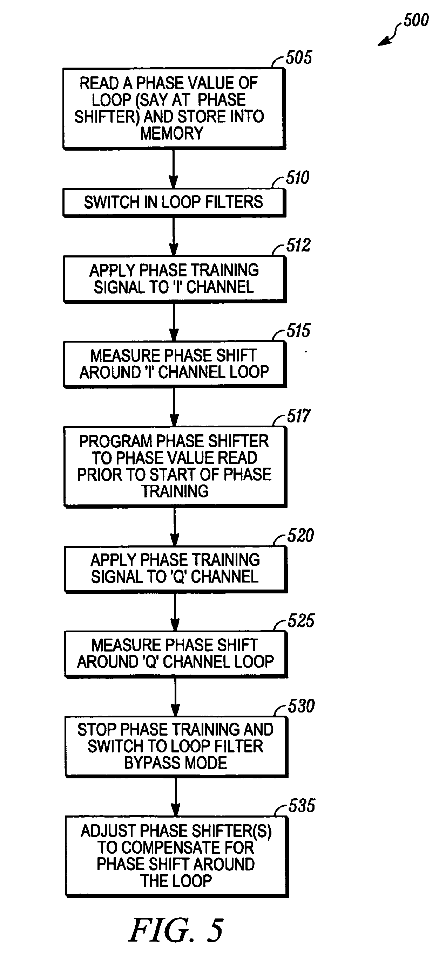

In summary, an improved phase and amplitude training process is illustrated in the flowchart 500 of FIG. 5. The linearisation training procedure may in this embodiment comprise a phase training process followed by an amplitude training procedure. First a value of phase (for example, a value of phase shifter 442 of FIG. 4) is read prior to phase training and stored into memory (as 'X' deg) in step 505. Low-pass (loop) filters are then switched into `I' and 'Q' feedback paths, as shown in step 510. A phase training signal, is input to a first quadrature loop, for example an 'I' channel loop, in step 512. A phase shift exerted upon a phase training signal around the `I' channel loop is then measured in step 515.

This measured phase shift is calculated and programmed into memory. The phase shift is then returned to the original value (for example, the value prior to phase training, namely 'X' degrees), as shown in step 517. The same phase training signal may then be input to the second quadrature loop, for example a 'Q' channel loop, in step 520. The phase shift exerted upon the phase training signal around the 'Q' channel loop is then measured in step 525 and programmed into memory. Using the respective phase shifts that were measured in steps 515 and 525, the phase training process is complete and switches are re-configured to bypass the low-pass filters in step 530. Phase shifter(s) in a feedback path are then adjusted to compensate for phase shift around the loop, in readiness for amplitude training and/or normal transmissions.

It is within the contemplation of the invention that the phase shifter may be adjusted after performing both I-channel phase training and Q-channel phase training. However, it is envisaged that in some circumstances the phase-shifter may be adjusted after each individual phase calculation has been made.

In summary, a new phase training circuit for elimination of errors in a Cartesian feedback loop linear transmitter has been described. One or more of the aforementioned embodiments may provide a mechanism for reducing potential risks of nearby transmissions affecting an accuracy of a phase training method.

It is envisaged that integrated circuit manufacturers may utilise embodiments of the invention hereinbefore described. For example, it is envisaged that a radio frequency linearised transmitter integrated circuit (IC) containing the aforementioned transmitter circuit arrangement and method of training could be manufactured to be incorporated into a wireless communication unit.

Advantageously, the embodiments of the invention may provide a significant benefit to manufacturers of linearised transmitter circuits, by improving an accuracy of a phase training process. For example, it is also within the contemplation of the invention that alternative linearisation techniques may benefit from the embodiments described herein. As an alternative to using Cartesian feedback, a pre-distortion form of lineariser may be adapted to implement embodiments of the invention. Y. Nagata described an example of a suitable pre-distortion transmitter configuration in the 1989 IEEE paper titled "Linear Amplification Technique for Digital Mobile Communications".

Furthermore, it is within the contemplation of the invention that the wireless communication unit employing the linearised transmitter may be any wireless communication device, such as a portable or mobile private mobile radio, a mobile phone, a personal digital assistant, a wireless laptop computer, etc. It is also envisaged that embodiments of the invention described herein are not limited to use in subscriber equipment, but may also be utilised in other communication units, such as base station equipment.

It will be understood that the wireless communication unit, linearised transmitter circuit and method of training, as described above, tend to provide at least one or more of the following advantages:
(i) The improved phase training circuit and method results in a more stable output of the linearised transmitter circuit.
(ii) The improved phase training result is more robust and accurate as it reduces the potentially damaging effects of high-power nearby, linear transmitting communication unit's channel. Hence, reduced tolerance components may be used in the loop I/Q generators.
(iii) The improved phase training results in a better wideband noise performance.

It will be appreciated that references to specific functional devices or elements are only to be seen as references to suitable means for providing the described functionality, rather than indicative of a strict logical or physical structure or organization of components.

Aspects of the invention may be implemented in any suitable form. The signal determining logic, for example, may be located in any portion of the receiver chain and may be physically, functionally and/or logically implemented in any suitable manner.

In the foregoing specification, specific embodiments of the present invention have been described. However, one of ordinary skill in the art appreciates that various modifications and changes can be made without departing from the scope of the present invention as set forth in the claims below. Accordingly, the specification and figures are to be regarded in an illustrative rather than a restrictive sense, and all such modifications are intended to be included within the scope of present invention. The benefits, advantages, solutions to problems, and any element(s) that may cause any benefit, advantage, or solution to occur or become more pronounced are not to be construed as a critical, required, or essential features or elements of any or all the claims. The invention is defined solely by the appended claims including any amendments made during the pendency of this application.

Moreover in this document, relational terms such as first and second, top and bottom, and the like may be used solely to distinguish one entity or action from another entity or action without necessarily requiring or implying any actual such relationship or order between such entities or actions. The terms "comprises," "comprising," "has", "having," "includes", "including," "contains", "containing" or any other variation thereof, are intended to cover a non-exclusive inclusion, such that a process, method, article, or apparatus that comprises, has, includes, contains a list of elements does not include only those elements but may include other elements not expressly listed or inherent to such process, method, article, or apparatus. An element proceeded by "comprises ... a", "has ... a", "includes ... a", "contains ... a" does not, without more constraints, preclude the existence of additional identical elements in the process, method, article, or apparatus that comprises, has, includes, contains the element. The terms "a" and "an" are defined as one or more unless explicitly stated otherwise herein. The terms "substantially", "essentially", "approximately", "about" or any other version thereof, are defined as being close to as understood by one of ordinary skill in the art. The term "coupled" as used herein is defined as connected, although not necessarily directly and not necessarily mechanically. A device or structure that is "configured" in a certain way is configured in at least that way, but may also be configured in ways that are not listed.

Thus, a wireless communication unit, a linearised transmitter integrated circuit and improved training mechanism have been described that substantially addresses the problems associated with known linearised transmitters.

## Claims

1. A wireless communication unit (300) comprising a linearised transmitter (325, 500) having:
a power amplifier (324) for transmitting a linearised radio signal;
a forward path for routing a signal to be transmitted by the power amplifier (324);
a feedback path, operably coupled to the power amplifier (324) and the forward path for feeding back a portion of the power amplifier's (324) output signal to be transmitted; and **characterised by**:
a processor (314, 460) for applying one or more phase training signals to the forward path,
wherein one or more filters (490, 492) are switched into the feedback path when the one or more phase training signals are applied, and the processor is arranged to bypass the one or more filters (490, 492) when the one or more phase training signals are not applied.

2. The wireless communication unit (300) of claim 1 further **characterised in that** a cut-off frequency of the one or more filters (490, 492) is programmable.

3. The wireless communication unit (300) of any preceding claim wherein the wireless communication unit (300) is further **characterised in that** the one or more filters (490, 492) is switched into the feedback path during a phase training process in response to identifying a nearby interfering transmission.

4. The wireless communication unit (300) of any preceding claim further **characterised by** the linearised transmitter (325, 500) being a Cartesian feedback linearised transmitter.

5. The wireless communication unit (300) of any preceding claim wherein the wireless communication unit is capable of operation on a TErrestrial Trunked RAdio (TETRA) communication system.

6. The wireless communication unit (300) of any preceding claim wherein the wireless communication unit is a subscriber unit or a base transceiver station.

7. A method of linearising a transmitter (500) which comprises a forward path, a feedback path, a power amplifier (324) and loop adjustment logic, the method **characterised by** comprising:
applying one or more phase training signals (512, 520) to be routed through the forward path of the linearised transmitter;
switching into the feedback path one or more filters (490, 492) when the one or more phase training signals are applied; and
bypassing the one or more filters (490, 492) when the one or more phase training signals are not applied.

## Patentansprüche

1. Drahtlose Kommunikationseinheit (300), umfassend einen linearisierten Sender (325, 500) mit:
einem Kraftverstärker (324) zum Senden eines linearisierten Radiosignals;
einem Sendepfad zum Leiten eines Signals, um durch den Kraftverstärker (324) gesendet zu werden;
einem an den Kraftverstärker (324) und den Sendepfad betriebsbereit gekoppelten Rückkopplungspfad zur Rückkopplung eines gesendet zu werdenden Teils des Ausgangssignals des Kraftverstärker (324); und **gekennzeichnet durch**:
einem Prozessor (314, 460) zur Anlegung eines oder mehrerer Phasentrainingssignale auf den Sendepfad, wobei einer oder mehrere Filter (490, 492) in den Rückkopplungspfad geschaltet sind, wenn die einen oder mehreren Phasentrainingssignale angelegt sind, und wobei der Prozessor angeordnet ist, um den einen oder die mehreren Filter (490, 492) zu umgehen, wenn das eine oder die mehreren Phasentrainingssignale nicht angelegt sind.

2. Drahtlose Kommunikationseinheit (300) nach Anspruch 1, ferner **dadurch gekennzeichnet, dass** eine Grenzfrequenz des einen oder der mehreren Filter (490, 492) programmierbar ist.

3. Drahtlose Kommunikationseinheit (300) nach einem der vorangehenden Ansprüche, wobei die drahtlose Kommunikationseinheit (300) ferner **dadurch gekennzeichnet ist, dass** der eine oder die mehreren Filter (490, 492) während eines Phasentrainingsprozesses in Antwort auf eine Identifizierung einer nahen interferierenden Übertragung in den Rückkopplungspfad geschaltet ist.

4. Drahtlose Kommunikationseinheit (300) nach einem der vorangehenden Ansprüche, ferner **dadurch gekennzeichnet, dass** der linearisierte Sender (325, 500) ein kartesischer linearisierter Rückkopplungssender ist.

5. Drahtlose Kommunikationseinheit (300) nach einem der vorangegangenen Ansprüche, wobei die drahtlose Kommunikationseinheit geeignet ist ein TErrestrial Trunked RAdio (TETRA, terrestrischer Bündelfunk) Kommunikationssystem zu betreiben.

6. Drahtlose Kommunikationseinheit (300) nach einem der vorangegangenen Ansprüche, wobei die drahtlose Kommunikationseinheit eine Teilnehmereinheit oder eine Basissendeempfängerstation ist.

7. Verfahren zur Linearisierung eines Senders (500), der einen Sendepfad, einen Rückkopplungspfad, einem Kraftverstärker (324) und eine Schleifenanpassungslogik umfasst, wobei das Verfahren **gekennzeichnet ist durch** umfassen von:
Anlegen von einem oder mehreren Phasentrainingssignalen (512, 520), um durch den Sendepfad des linearisierten Senders geleitet zu werden;
Schalten von einem oder mehreren Filtern (490, 492) in den Rückkopplungspfad, wenn das eine oder die mehreren Phasentrainingssignale angelegt werden; und
Umgehen des einen oder der mehreren Filter (490, 492), wenn das eine oder die mehreren Phasentrainingssignale nicht angelegt sind.

## Revendications

1. Unité de communication sans fil (300) comprenant un émetteur linéarisé (325, 500) ayant :
un amplificateur de puissance (324) pour la transmission d'un signal radio linéarisé ;
une voie d'aller pour l'acheminement d'un signal à transmettre par l'amplificateur de puissance (324) ;
une voie de retour, couplée en liaison fonctionnelle à l'amplificateur de puissance (324) et à la voie d'aller, pour la réinjection d'une partie du signal de sortie de l'amplificateur de puissance (324) à transmettre ; et
**caractérisée par** :
un processeur (314, 460) pour appliquer un ou plusieurs signaux d'apprentissage de phase sur la voie d'aller, un ou plusieurs filtres (490, 492) étant commutés sur la voie de retour lorsque le ou les signaux d'apprentissage de phase sont appliqués, et le processeur étant conçu pour contourner le ou les filtres (490, 492) lorsque le ou les signaux d'apprentissage de phase ne sont pas appliqués.

2. Unité de communication sans fil (300) selon la revendication 1, **caractérisée en outre en ce qu'**une fréquence de coupure du ou des filtres (490, 492) est programmable.

3. Unité de communication sans fil (300) selon l'une quelconque des revendications précédentes, laquelle unité de communication sans fil (300) est en outre **caractérisée en ce que** le ou les filtres (490, 492) sont commutés sur la voie de retour pendant un processus d'apprentissage de phase en réponse à une identification d'une transmission brouilleuse à proximité.

4. Unité de communication sans fil (300) selon l'une quelconque des revendications précédentes, **caractérisée en outre par le fait que** l'émetteur linéarisé (325, 500) est un émetteur linéarisé à retour d'information cartésien.

5. Unité de communication sans fil (300) selon l'une quelconque des revendications précédentes, laquelle unité de communication sans fil peut fonctionner sur un système de communication TETRA (TErrestrial Trunked RAdio).

6. Unité de communication sans fil (300) selon l'une quelconque des revendications précédentes, laquelle unité de communication sans fil est une unité d'abonné ou une station émettrice-réceptrice de base.

7. Procédé de linéarisation d'un émetteur (500) qui comprend une voie d'aller, une voie de retour, un amplificateur de puissance (324) et une logique d'ajustement par boucle, le procédé étant **caractérisé en ce qu'**il comprend :
l'application d'un ou plusieurs signaux d'apprentissage de phase (512, 520) à acheminer par la voie d'aller de l'émetteur linéarisé ;
la commutation sur la voie de retour d'un ou plusieurs filtres (490, 492) lorsque le ou les signaux d'apprentissage de phase sont appliqués ; et
le contournement du ou des filtres (490, 492) lorsque le ou les signaux d'apprentissage de phase ne sont pas appliqués.
